Europäisches Patentamt

European Patent Office

Office européen des brevets

(11) Veröffentlichungsnummer: **0 136 643**
**A2**

## (12) EUROPÄISCHE PATENTANMELDUNG

(21) Anmeldenummer: **84111369.9**

(22) Anmeldetag: **24.09.84**

(51) Int. Cl.⁴: **H 04 R 25/02**

(30) Priorität: **05.10.83 DE 3336266**

(43) Veröffentlichungstag der Anmeldung:
**10.04.85 Patentblatt 85/15**

(84) Benannte Vertragsstaaten:
**AT CH DE FR GB IT LI NL SE**

(71) Anmelder: **Siemens Aktiengesellschaft**
**Berlin und München Wittelsbacherplatz 2**
**D-8000 München 2(DE)**

(72) Erfinder: **Härtl, Christof**
**Rodensteinstrasse 2**
**D-8524 Neunkirchen(DE)**

(72) Erfinder: **Wagner, Hans**
**Im Eichengarten 6**
**D-8520 Erlangen(DE)**

(54) Hörgerät.

(57) Die Erfindung bezieht sich auf ein Hörgerät mit einem wenigstens weitgehend in den äußeren Gehörgang einführbaren Gehäuse (1) und einer das Gehäuse nach aussen abschließenden Abschlußplatte (2) sowie einer im Gehäuseinneren liegenden gedruckten Schaltung mit elektrischen Bauelementen, bei dem die gedruckte Schaltung auf einer biegsamen Folie aufgebracht ist. Die Folie weist einen Teil der Schaltung (10) an einem Ausleger (11) auf und besitzt eine von Bauelementen freie Biegezone (12). Sie ist mit ihrem diejenigen Bauelemente, die von außen bedient werden. aufweisenden Teil (13) an der Innenseite der Abschlußplatte (2) befestigt und mit ihrem anderen Teil (15) von dieser Innenseite aus nach innen abgebogen.

FIG 3

SIEMENS AKTIENGESELLSCHAFT          Unser Zeichen
Berlin und München                  VPA 83 P 3 3 4 6 E

— 1 —

Hörgerät

Die Erfindung betrifft ein Hörgerät mit einem wenigstens weitgehend in den äußeren Gehörgang einführbaren Gehäuse und einer das Gehäuse nach außen abschließenden Abschlußplatte sowie mit einer im Gehäuseinneren liegenden gedruckten Schaltung mit elektrischen Bauelementen, bei dem die gedruckte Schaltung auf einer biegsamen Folie angebracht ist.

Bei Hörgeräten dieser Art ist es für eine Miniaturisierung erforderlich, daß die gedruckte Schaltung möglichst platzsparend im Gehäuseinneren angeordnet wird, so daß das Gehäuseinnere möglichst weitgehend mit den Bauelementen ausgefüllt wird und die Außenabmessungen des Hörgerätes sehr klein gehalten werden können. Hierzu ist es bekannt, die gedruckte Schaltung auf einer flexiblen Folie anzuordnen, die Ansätze für die Anschlüsse des Lautsprechers, des Mikrofons und der Batterie aufweist. Die eigentliche Schaltung ist dabei in einem Zentralteil der Folie angeordnet. Die Anschlüsse können in den Hohlraum des Hörgerätes hineingebogen werden.

Der Erfindung liegt die Aufgabe zugrunde, ein Hörgerät der eingangs genannten Art in der Hinsicht noch weiter zu verbessern, daß durch die gedruckte Schaltung der Hohlraum des Hörgerätes besser als beim Stand der Technik ausgefüllt wird und damit eine weitere Miniaturisierung möglich ist.

Diese Aufgabe ist erfindungsgemäß dadurch gelöst, daß die Folie einen Teil der Schaltung an einem Ausleger

Tp 2 Kof - 03.10.1983

aufweist, eine von Bauelementen freie Biegezone besitzt, mit ihrem diejenigen Bauelemente, die von außen bedient werden, aufweisenden Teil an der Innenseite der Abschlußplatte befestigt und mit ihrem anderen Teil von dieser Innenseite aus nach innen abgebogen ist. Bei dem erfindungsgemäßen Hörgerät kann zunächst der Teil der Schaltung, der am Ausleger der Folie sitzt, in den Innenraum des Hörgerätes hineingebogen werden. Nur derjenige Teil der Folie, der die von außen zu bedienenden Bauelemente trägt, liegt an der Innenseite der Abschlußplatte an. Der restliche Teil wird durch Abwinkelung der Folie in der Biegezone ebenfalls in das Innere des Hörgerätes hineingebogen. Auf diese Weise ist eine optimale Ausnutzung des zur Verfügung stehenden Raumes gewährleistet. Diejenigen Bauelemente, die in dem Teil der Folie angeordnet sind, der an der Innenseite der Abschlußplatte liegt, können beispielsweise ein Potentiometer für die Lautstärkeregelung und ein Netzwerk zum Festlegen der gewünschten Übertragungscharakteristik der zu übertragenden Signale sein.

Eine zweckmäßige Ausgestaltung der Erfindung besteht darin, daß die Folie so angeordnet ist, daß der nach innen abgewinkelte Teil neben der an einem Deckel der Abschlußplatte innen gelagerten Batterie liegt und daß dieser Teil in seiner Form der Batterie so angepaßt ist, daß er diese nicht überragt. Bei dieser Ausgestaltung liegt der nach innen abgewinkelte Teil der Folie neben der Batterie, wo genügend Raum für elektrische Bauelemente zur Verfügung steht. Der Winkel zwischen dem an der Innenseite der Abschlußplatte anliegenden Teil der Folie und dem abgewinkelten, neben der Batterie liegenden Teil der Folie beträgt in diesem Fall etwa $90^{\circ}$.

Die Erfindung ist nachfolgend anhand eines in der Zeichnung dargestellten Ausführungsbeispiels näher erläutert.

Es zeigen:

Figur 1 eine Außenansicht eines Hörgerätes nach
der Erfindung,

Figur 2 eine Ansicht der Abschlußplatte des Hörgerätes gemäß Figur 1 von innen und

Figur 3 einen Schnitt durch die Abschlußplatte
des Hörgerätes gemäß Figur 1.

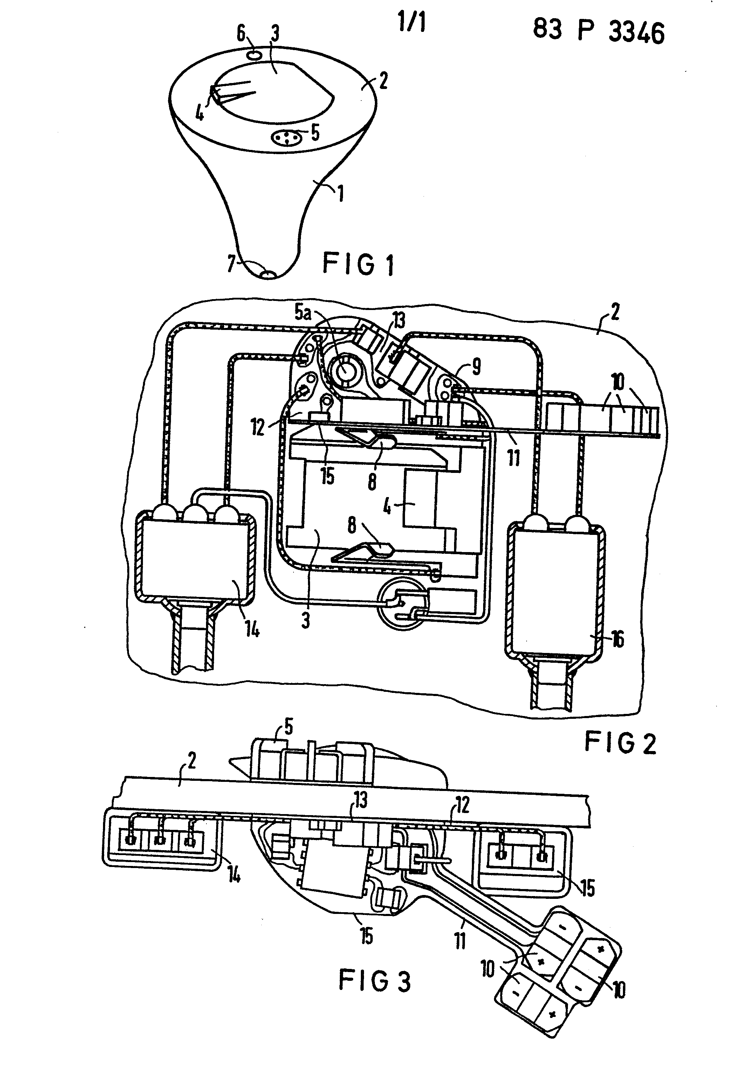

In der Figur 1 ist ein aus Kunststoff bestehendes Gehäuse 1 eines Hörgerätes dargestellt, das in den Ohrkanal des Benutzers eingeführt wird. Der Innenraum des
Gehäuses 1 ist durch eine Abschlußplatte 2 mit einem
Deckel 3 begrenzt. Der Deckel 3 ist mit Hilfe eines
Ansatzes 4 aus der Abschlußplatte 2 herausschwenkbar
und trägt auf seiner Innenseite mit Hilfe eines in der
Figur 2 sichtbaren Ansatzes 4 eine Batterie zur Speisung der elektrischen Schaltung. Auf der Außenseite
der Abschlußplatte 2 ist ein Stellglied 5 zur Einstellung der Lautstärke angeordnet. Ferner ist eine Schalleintrittsöffnung 6 und eine Schallaustrittsöffnung 7
erkennbar.

Die Figur 2 zeigt die Rückseite der Abschlußplatte 2
mit dem elektrischen Teil des Hörgerätes. Neben dem
Deckel 3 sind zwei Federn 8 erkennbar, zwischen denen
die nicht dargestellte Batterie eingeklemmt wird. Die
elektrischen Bauelemente sind mit Hilfe einer gedruckten Schaltung auf einer biegsamen Folie 9 miteinander
elektrisch verbunden. Die Folie 9 weist einen Teil der
Schaltung mit den Bauelementen 10 an einem Ausleger 11
auf. Sie besitzt eine von Bauelementen freie Biegezone 12. Mit ihrem diejenigen Bauelemente, die von
außen bedient werden, aufweisenden Teil 13 ist sie an der Innenseite der Abschlußplatte 2 befestigt. Dieser Teil beinhaltet insbesondere ein Potentiometer 5a, das durch das Stellglied 5 verstellbar ist.

Die biegsame Folie 9 besitzt ferner einen von der Innenseite der Abschlußplatte 2 aus in das Innere des Gehäuses 1 hineinragenden Teil 15 mit weiteren Bauelementen, die insbesondere in der Figur 3 sichtbar sind. Die Form dieses Teils 15, der etwa senkrecht von der Abschlußplatte 2 aus wegragt, entspricht der Kontur der Batterie, so daß er neben dieser nicht vorsteht.

In den Figuren 2 und 3, die einen im Vergleich zu Figur 1 vergrößerten Maßstab aufweisen, sind noch ein Mikrofon 14 und ein Lautsprecher 16 sichtbar, die mit Hilfe flexibler Leitungen mit der gedruckten Schaltung verbunden und im Inneren des Gehäuses 1 in geeigneter Weise angebracht werden. Insbesondere werden die Eingangs- bzw. Ausgangsöffnungen des Mikrofons 14 bzw. des Hörers 16 mit Hilfe von Schläuchen mit den Öffnungen 6 bzw. 7 verbunden.

Aus den Figuren 2 und 3 geht hervor, daß die gedruckte Schaltung mit den auf der Folie 9 angeordneten Bauelementen den Hohlraum des Hörgerätes optimal nutzt. Dies ist insbesondere auch deshalb möglich, weil der Ausleger 11 mit den Bauelementen 10 jeweils so ausgerichtet werden kann, daß er an einer geeigneten Stelle im Inneren des Hörgerätes liegt. Auf diese Weise ist es demgemäß möglich, alle Bauelemente auch bei sehr kleinen Abmessungen des Hörgerätes unterzubringen. Der in der Tiefe zur Verfügung stehende Raum wird dabei optimal genutzt, so daß auch kleine Ohren vorteilhaft versorgt werden können.

2 Patentansprüche

3 Figuren

Patentansprüche

1. Hörgerät mit einem wenigstens weitgehend in den äußeren Gehörgang einführbaren Gehäuse (1) und einer das Gehäuse (1) nach außen abschließenden Abschlußplatte (2) sowie einer im Gehäuseinneren liegenden gedruckten Schaltung mit elektrischen Bauelementen, bei dem die gedruckte Schaltung auf einer biegsamen Folie (9) aufgebracht ist, d a d u r c h g e k e n n z e i c h n e t , daß die Folie (9) einen Teil der Schaltung (10) an einem Ausleger (11) aufweist, eine von Bauelementen freie Biegezone (12) besitzt, mit ihrem diejenigen Bauelemente (5a), die von außen bedient werden, aufweisenden Teil (13) an der Innenseite der Abschlußplatte (2) befestigt und mit ihrem anderen Teil (15) von dieser Innenseite aus nach innen abgebogen ist.

2. Hörgerät nach Anspruch 1, d a d u r c h g e - k e n n z e i c h n e t , daß die Folie (9) so angeordnet ist, daß der nach innen abgewinkelte Teil(15) neben der an einem Deckel (3) der Abschlußplatte (2) innen gelagerten Batterie liegt und daß dieser Teil (15) in seiner Form der Batterie so angepaßt ist, daß er diese nicht überragt.

83 P 3346

FIG 1

FIG 2

FIG 3